**Europäisches Patentamt**

**European Patent Office**

**Office européen des brevets**

(11) Publication number: **0 509 312 B1**

# EUROPEAN PATENT SPECIFICATION

(45) Date of publication of patent specification: **23.08.95**   (51) Int. Cl.⁶: **C30B 15/00**

(21) Application number: **92105551.3**

(22) Date of filing: **31.03.92**

(54) **Czochralski method using a member for intercepting radiation from raw material molten solution and apparatus therefor.**

(30) Priority: **16.04.91 JP 83770/91**
**22.08.91 JP 210786/91**

(43) Date of publication of application:
**21.10.92 Bulletin 92/43**

(45) Publication of the grant of the patent:
**23.08.95 Bulletin 95/34**

(84) Designated Contracting States:
**DE FR GB**

(56) References cited:
**EP-A- 0 390 503**
**GB-A- 2 139 918**

(73) Proprietor: **SUMITOMO ELECTRIC INDUS-TRIES, LIMITED**
**5-33, Kitahama 4-chome**
**Chuo-ku**
**Osaka 541 (JP)**

(72) Inventor: **Tatsumi, Masami, c/o Itami Works of Sumitomo**
**Electric Industries Ltd,**
**1-1, Koyakita 1-chome**
**Itami-shi,**
**Hyogo (JP)**
Inventor: **Sawada, Shin-ichi, c/o Itami Works of Sumitomo**
**Electric Industries Ltd,**
**1-1, Koyakita 1-chome**
**Itami-shi,**
**Hyogo (JP)**

(74) Representative: **Herrmann-Trentepohl, Werner, Dipl.-Ing. et al**
**Patentanwälte Herrmann-Trentepohl,**
**Kirschner, Grosse, Bockhorni & Partner**
**Forstenrieder Allee 59**
**D-81476 München (DE)**

## Description

BACKGROUND OF THE INVENTION

Field of the Invention

The present invention relates to a method and an apparatus for manufacturing a single crystal by Czochralski method and, more specifically, it relates to a method and an apparatus for manufacturing, in accordance with Czochralski method, a single crystal of, III-V compound semiconductor such as GaAs and InP, II-VI compound semiconductor such as CdTe, a semiconductor such as Si, and Ge, an oxide such as $LiNbO_3$, $TiO_2$ and BSO.

Description of the Background Art

In manufacturing of a single crystal in accordance with Czochralski method, a technique for controlling the diameter of the single crystal to be formed and for controlling the shape of the solid-liquid interface is very important to form the single crystal with stability while suppressing generation of crystal defects such as dislocation, formation of polycrystal and twin. Methods and apparatuses employing a member for carrying out such control in a crucible containing raw material molten solution for pulling the single crystal by means of this member have been developed for the Czochralski method.

For example, Japanese Patent Laying-Open Nos. 57-7897 and 61-63596 disclose apparatuses in which a molding body having an opening at the center is provided above the raw material molten solution. In these apparatuses, the shape of the pulled crystal is controlled as the single crystal is pulled through the opening of the molding body.

Japanese Patent Laying-Open No. 62-288193 discloses a method in which a molding body having an inverted conical shape is dipped in the raw material molten solution contained in the crucible and the single crystal is pulled from the raw material molten solution flowing in the molding body. In this method, by moving the molding body and the crucible relative to each other, the cross sectional area of the super cooled part of molten solution formed in the molding body is changed. By adjusting the cross section at steps of forming the shoulder portion, forming cylindrical body and forming tail portion, rapid growth of the crystal can be suppressed.

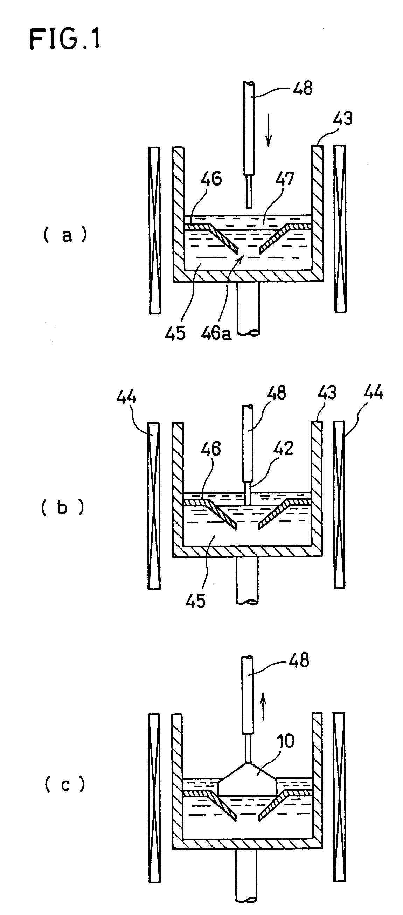

The inventors of the present invention have studied a method and apparatus in which a coracle having a communicating hole provided at the bottom floats on the raw material molten solution for pulling a single crystal from the raw material molten solution flowing through the communicating hole to the coracle. The coracle is used in the following manner, for example, in order to control diameter and shape of the single crystal to be grown. Referring to Fig. 1 (a), raw material molten solution 45 and liquid encapsulant 47 are contained in a crucible 43, and a coracle 46 is dipped therein. The coracle 46 is adjusted to have an appropriate specific gravity, so that it floats on the raw material molten solution. The raw material molten solution flows through a communicating hole 46a into the floating coracle 46. The surface of the raw material molten solution in the coracle has an appropriate diameter. Referring to Fig. 1 (b), an upper shaft 48 is lowered, and a seed crystal 42 provided at the lower end thereof is dipped in the raw material molten solution in the coracle 46. At this time, the temperature of the raw material molten solution is adjusted by means of a heater 44 provided around the crucible 43. Then, referring to Fig. 1 (c), the upper shaft 48 is slowly elevated and a single crystal 10 is pulled.

The above described methods and apparatuses have been proposed to enable stable growth of the single crystal. However, when the crystal is to be pulled by making small the temperature gradient in the direction of pulling or when a crystal having relatively low thermal conductivity, it is often difficult to manufacture a crystal with low dislocation density by the above described methods and apparatuses.

In the above described method or apparatus, emission of heat from the raw material molten solution is considered to be a major factor causing higher dislocation density. In order to suppress heat radiation, various methods or measures have been proposed. For example, Japanese Utility Model Laying Open No. 60-172772 discloses a crystal pulling apparatus in which at least one heat intercepting plate is provided in the longitudinal direction of the shaft for pulling the crystal, in order to suppress heat convection from the raw material molten solution. Japanese Patent Laying-Open No. 60-81089 discloses a method in which an elongate crucible is used and a crystal is pulled while the raw material molten solution is covered by the sidewall of the crucible and a reflector for reflecting heat-ray provided on a crystal pulling shaft. Further, Japanese Patent Laying-Open No. 60-118699 discloses an apparatus including a member for suppressing heat radiation and heat convection from the raw material molten solution, through which member the crystal

2

EP 0 509 312 B1

pulling shaft is provided above the crucible.

The conventional apparatus or method employing a member for suppressing radiation or convection enables manufacturing of a crystal with low dislocation density. However, when the crystal is to be pulled with temperature gradient in the direction of pulling made smaller or when a crystal having relatively low thermal conductivity is to be pulled, it was often difficult by such method or apparatus to suppress rapid growth of the crystal specially at the start of pulling. Rapid growth of crystal causes formation of twins or polycrystals and makes it difficult to manufacture a single crystal with high reproducibility. Especially when a crystal of a material having low thermal conductivity such as CdTe is to be pulled, it was difficult to pull the single crystal with high reproducibility, because of rapid growth at the start of pulling.

When a crystal of GaAs or CdTe is to be pulled, emission of heat from the raw material molten solution is an important cause of the rapid growth of the crystal at pulling. The conventional apparatus and method could not sufficiently suppress the emission of heat at pulling the crystal. Most of the emission of heat is considered to be derived from radiation. Therefore, effective interception of radiation was necessary to suppress effectively the heat emission. If the radiation is intercepted nearer to the raw material molten solution, heat emission can be more effectively suppressed. The mechanism for intercepting radiation at an upper portion of the crucible provided in the conventional apparatus is not effective enough, and it was necessary to intercept radiation near the raw material molten solution. Interception of radiation is considered to be not sufficient even in the method or apparatus in which a shaft for pulling the crystal is lowered so as to bring near the radiation intercepting member to the material as in the prior art, trying to improve suppression of heat emission.

SUMMARY OF THE INVENTION

An object of the present invention is to provide a method and apparatus in which radiation from raw material molten solution can be effectively intercepted especially at the start of pulling when temperature gradient in the direction of pulling is small, enabling sufficient suppression of rapid growth of the crystal to be pulled and enabling formation of a crystal with low dislocation density.

Another object of the present invention is to provide a method and apparatus capable of sufficient suppression of rapid growth of a crystal and of forming a crystal with low dislocation density, by effectively intercepting radiation especially at the start of pulling when a single crystal of a material having low thermal conductivity (for example, CdTe) is to be pulled.

A further object of the present invention is to provide a method and apparatus for manufacturing a single crystal with high yield, by effectively suppressing rapid growth of the crystal.

According to one aspect of the present invention, a method of forming a single crystal by bringing a seed crystal attached at a lower end of a crystal pulling shaft into contact with a raw material molten solution and by pulling the seed crystal by the crystal pulling shaft is provided. The method of the present invention includes the step of providing, in the raw material molten solution, a coracle having an opening capable of containing the raw material molten solution therein so that the surface of the raw material molten solution has a prescribed size; the first step of intercepting radiation by providing a first member having an opening for passing a seed crystal at the center to cover the surface of the raw material molten solution in the coracle, so as to intercept radiation from the raw material molten solution to the upper portion of the coracle; the second step of intercepting radiation by covering the opening with a second member supported by the crystal pulling shaft when the seed crystal is brought into contact with the raw material molten solution, so as to intercept radiation through the opening; the step of seeding by bringing the seed crystal into contact with the raw material molten solution by lowering the crystal pulling shaft while intercepting radiation by the first and second members; the shoulder forming step for forming the shoulder portion of the single crystal by elevating the crystal pulling shaft while intercepting radiation by the first and second members after the step of seeding; and the cylindrical body forming step after the shoulder forming step for forming the cylindrical body portion of the single crystal from the raw material molten solution in the coracle while pulling the first member as well as the crystal pulling shaft.

According to the present invention, from the first step of intercepting radiation to the step of forming the shoulder portion, radiation can be further intercepted by covering the first member by a third member provided above the first member and having an opening through which the second member is passed.

Preferably, the aforementioned first member should cover the raw material molten solution as nearer as possible to the surface of the raw material molten solution. For example, if the first member covers the surface of the raw material molten solution within 50mm above the surface of the raw material molten solution, radiation can be sufficiently intercepted.

3

The inner diameter of the opening portion of the first member should be as small as possible so as to effectively intercept the radiation from the raw material molten solution. More specifically, the radiation escaping from the opening portion can be reduced when the gap between the seed crystal and the first member (D-d)/2 is made smaller, where D denotes the inner diameter of the opening portion and d denotes the diameter of the seed crystal. On the other hand, this gap must be large enough to enable the seed crystal to be passed through the opening portion smooth even if the seed crystal is vibrated because of rotation or the like. From these view points, the gap (D-d)/2 should preferably be in the range of 2 to 20mm.

In the present invention, radiation may be intercepted by a single member formed by integrating the first and second members.

Further, from the first step of intercepting radiation to the step of forming the shoulder portion, radiation from the heat source may be provided to the surface of and above the raw material molten solution.

The above described method of the present invention may be carried out in accordance with liquid encapsulated Czochralski method in which the single crystal is pulled with a liquid encapsulant provided on the raw material molten solution. The method of the present invention may be carried out under a pressurized atmosphere including raw material constituent.

Further, the method of the present invention is especially useful for forming a crystal having low thermal conductivity. The method of the present invention may be used as a method for forming a CdTe crystal or a CdTe crystal containing, as an impurity, Zn, Se, Hg, Mn, In, Ga or Cl.

According to another aspect of the present invention, an apparatus for manufacturing a single crystal including crucible for containing a raw material molten solution; a lower shaft for supporting the crucible; a heater arranged around three crucible; a coracle provided in the crucible and having an opening capable of containing therein the raw material molten solution such that the surface of the raw material molten solution has a prescribed size; a rotatable/vertically movable upper shaft at the lower end of which a seed crystal for pulling a single crystal from the raw material molten solution is attached; a first radiation intercepting member having an opening at the central portion through which the seed crystal is inserted and provided movable above the coracle to cover the surface of the raw material molten solution so as to intercept upward radiation from the raw material molten solution in the coracle; and a second radiation intercepting member for covering the aforementioned opening supported by the upper shaft so as to intercept radiation through the opening of the first radiation intercepting member.

In the apparatus of the present invention, the coracle refers to a molding body containing the raw material molten solution provided in the crucible in order to control the diameter and the shape of the single crystal to be grown. Preferably, the coracle should be formed of a material which is stable at high temperature, which does not react with the raw material molten solution and which does not contaminate the single crystal to be grown. The coracle may be formed of a material such as carbon, quartz, BN, PBN, AlN, PBN coated carbon, carbon coated by glassy carbon, or carbon coated by pyrolytic carbon. In the apparatus of the present invention, the coracle may be float on the raw material molten solution in the crucible, or it may be provided in the crucible fixed to another member.

The apparatus in accordance with the present invention may include a third radiation intercepting member having an opening through which the second radiation intercepting member is passed for covering the first radiation intercepting member so as to further intercept the radiation above the first radiation intercepting member. The aforementioned first radiation intercepting member should preferably cover the raw material molten solution as nearer as possible to the surface of the raw material molten solution so as to get improved effect of interception of radiation. If the first radiation intercepting member cover the surface of the raw material molten solution, within 50mm above the surface of the raw material molten solution for example, radiation can be more effectively intercepted.

Further, in the apparatus of the present invention, the first and second radiation intercepting member may be integrated.

The aforementioned first radiation intercepting member may be formed by stacking a plurality of disk-shaped members having openings of different diameters.

In addition, the inner diameter of the opening portion of the first radiation intercepting member should be as small as possible in order to effectively intercept the radiation from the raw material molten solution. Namely, if the gap (D-d)/2 between the seed crystal and the first member is made small where D denotes the inner diameter of the opening portion and d denotes the diameter of the seed crystal, radiation escaping from the opening portion can be reduced. On the other hand, the gap should be large enough to enable the seed crystal pass through the opening portion smooth even if the seed crystal is vibrated because of rotation or the like. From the above points, the gap (D-d)/2 should preferably be in the range of 2 to 20mm.

The above described radiation intercepting member should be formed by a material which is stable at a high temperature, capable of intercepting heat radiation from the raw material molten solution and which

4

EP 0 509 312 B1

does not contaminate the single crystal to be grown. The material for forming the member includes, for example, carbon pyrolytic graphite BN, PBN, alumina, zirconia, quartz (opaque quarts), AlN, SiN, beryllia, Mo, W, Ta and composite materials of these. In order to improve the effect of intercepting radiation, a material having low thermal conductivity and low emissivity should be selected out of these materials.

The apparatus of the present invention may further include means for letting radiation from heater to reach above and to the surface of the raw material molten solution. This means may be a window formed at an upper portion of the crucible so as to let radiation from the heater reach above and the surface of the raw material molten solution through the crucible. This window may be a simple opening with nothing fitted therein, or it may be fitted with quartz or PBN which transmits heat ray easily and does not contaminate the raw material molten solution. As an alternative, a translucent ceramics such as quartz or PBN may be used at least at the upper portion of the crucible, so that the heat ray from the heater can be radiated to the surface of and above the raw material molten solution through the upper portion of the crucible.

Further, a liquid encapsulant may be provided on the raw material molten solution in the apparatus in accordance with the present invention described above. Further, the apparatus of the present invention may include an air-tight container for pulling the single crystal in a volatile constituent atmosphere.

In the method or apparatus in accordance with the present invention, since the surface of the raw material molten solution in the coracle is covered by the first member mounted on the coracle, radiation from the raw material molten solution is intercepted except through the opening of the first member. Therefore, before seeding, most of the radiation can be intercepted. When the seed crystal is brought into contact with raw material molten solution, the radiation through the opening of the first member is intercepted by the second member supported by the crystal pulling shaft. Therefore, radiation from the surface of the raw material molten solution is substantially entirely intercepted. Further, at the step of seeding at which the crystal pulling shaft is lowered so that the seed crystal is in contact with the molten solution, the second member covers the opening of the first member, and accordingly, the radiation is kept intercepted. At the step of forming the shoulder portion of the crystal after seeding, the entire radiation is substantially intercepted by the first and second members. By starting pulling while intercepting the radiation in this manner, rapid growth of the crystal can be effectively prevented with high reproducibility. Consequently, generation of twins or polycrystal can be prevented remarkably while the shoulder portion of the crystal is formed.

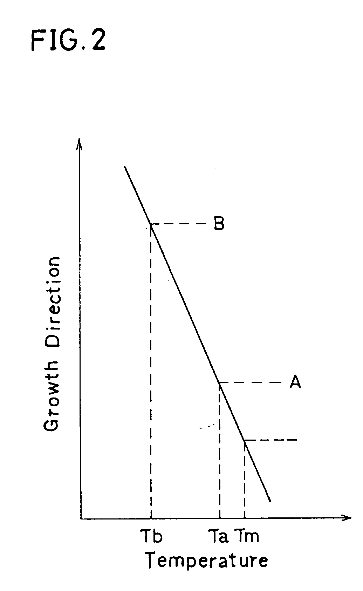

Since a single crystal is to be grown, temperature gradient in the direction of growth is necessary when the crystal is pulled. Assume that the temperature gradient such as shown in Fig. 2 is provided in the direction of growth. When the temperature of the material attain 1000°C or higher, the heat escaping above from the surface of the material is almost caused by radiation. Therefore, the radient heat flux q escaping from the material can be approximated by the following equation.

$$q = \sigma \ (T_1^{\ 4} - T_2^{\ 4}) \ \frac{1}{(1/\epsilon_1) + (1/\epsilon_2) - 1}$$

where
$T_1$: temperature of the material, $T_2$: temperature of an object above the material.
$\epsilon_1$: emissivity of the material, $\epsilon_2$: emissivity of an object above the material
$\sigma$: Stefan-Boltzmann constant

From the above equation, it is understood that q becomes smaller as the difference between $T_1$ and $T_2$ becomes smaller. It is understood from Fig. 2 that $T_m - T_b > T_m - T_a$, and therefore the amount of heat radiation from the surface of the raw material molten solution to the above becomes smaller when a heat insulating plate is provided at the position denoted by A, as compared with the position B. From the above analysis, it would be clear how important is the interception of radiation as near as possible to the surface of the raw material molten solution. By intercepting the radiation very close to the raw material molten solution in accordance with the present invention, the effect of keeping the temperature of the surface of the raw material molten solution can be significantly improved.

After the formation of the shoulder portion, the first member is elevated together with the crystal pulling shaft, placed on the shoulder portion of the crystal. The opening portion of the first member is not have to be so large as to pass the pulled crystal therethrough, and an opening large enough to pass the seed crystal is sufficient. Therefore, the amount of radiation through the opening portion of the first member can be minimized.

5

In addition, by using the third member, the heat ray escaping through the first member can be intercepted by the third member. By moving the second member together with the pulling shaft through the opening of the third member therebelow, the second member can be covered by the third member. Therefore, the heat ray escaping through the second member can be intercepted by the third member. Interception of radiation by these three members is especially effective when the temperature above these members is low.

Further, by radiating heat ray to the surface of and above the raw material molten solution from the first step of intercepting radiation to the step of formation of the shoulder portion of the crystal, cooling of the raw material molten solution can be suppressed more. By this radiation of heat ray, rapid growth of the crystal during forming the shoulder portion can be prevented.

As described above, by suppressing emission of heat from the surface of the raw material molten solution to the above, rapid growth at forming the shoulder portion can be suppressed and generation of polycrystal and twins can be suppressed significantly, when a crystal having low thermal conductivity or a crystal is to be formed with small temperature gradation in the pulling direction.

The coracle dipped in the raw material molten solution in the present invention keeps constant the diameter of the surface of the raw material molten solution from which the crystal is pulled. This is because the supply amount of the raw material molten solution necessary for pulling is appropriately controlled by introducing the raw material molten solution to the coracle. As this coracle is provided, the shoulder portion of the crystal having smooth shape can be surely formed, and the diameter of the cylindrical body portion of the crystal to be pulled can be controlled.

The foregoing and other objects, features, aspects and advantages of the present invention will become more apparent from the following detailed description of the present invention when taken in conjunction with the accompanying drawings.

## BRIEF DESCRIPTION OF THE DRAWINGS

Fig. 1 is a schematic diagram showing one embodiment of the conventional apparatus for manufacturing a single crystal.

Fig. 2 is a graph depicting the effect of bringing the first radiation intercepting member near the surface of the raw material molten solution in the method and apparatus in accordance with the present invention.

Fig. 3 is a schematic diagram of the apparatus for manufacturing a single crystal used in the first embodiment.

Figs. 4A to 4D are schematic diagrams showing the manner of pulling a single crystal from seeding by the apparatus shown in Fig. 3.

Fig. 5 is a perspective view showing the shape of the coracle used in the apparatus of Fig. 3.

Fig. 6 is a perspective view showing the first radiation intercepting member used in the apparatus of Fig. 3.

Fig. 7 is a perspective view showing the second radiation intercepting member used in the apparatus of Fig. 3.

Fig. 8 is a schematic diagram showing the apparatus for manufacturing a single crystal in accordance with a second embodiment.

Fig. 9 is a schematic diagram showing an apparatus for manufacturing a single crystal in accordance with a third embodiment.

Fig. 10 is a perspective view showing the first radiation intercepting member used in the apparatus of Fig. 9.

Fig. 11 is a schematic diagram showing the manner of forming the shoulder portion of the crystal in the apparatus shown in Fig. 9.

Fig. 12 is a schematic diagram of an apparatus for manufacturing a single crystal used in a fourth embodiment of the present invention.

Fig. 13 is a schematic diagram showing an apparatus in which the first member is supported by a supporter.

Fig. 14 is a schematic diagram of the apparatus used in the fifth embodiment.

Figs. 15A and 15B are cross sections showing other examples of the coracle used in the present invention.

Fig. 16 is a schematic diagram of an apparatus for manufacturing a single crystal used in a sixth embodiment.

Fig. 17 is a schematic diagram of an apparatus for manufacturing a single crystal used in a seventh embodiment.

Fig. 18 is a schematic diagram of an apparatus for manufacturing a single crystal used in an eighth embodiment.

Fig. 19 is a perspective view showing the shape of the third radiation intercepting member used in the apparatus of Fig. 18.

Figs. 20A to 20E are schematic diagrams showing the manner of pulling a single crystal from seeding by the apparatus shown in Fig. 18.

Fig. 21 is a schematic diagram of an apparatus for manufacturing a single crystal used in a ninth embodiment.

Fig. 22 is a schematic diagram of an apparatus for manufacturing a single crystal used in a tenth embodiment.

Fig. 23 is a schematic diagram showing an apparatus for manufacturing a single crystal used in the eleventh embodiment.

DESCRIPTION OF THE PREFERRED EMBODIMENTS

The first embodiment of the present invention will be described in the following.

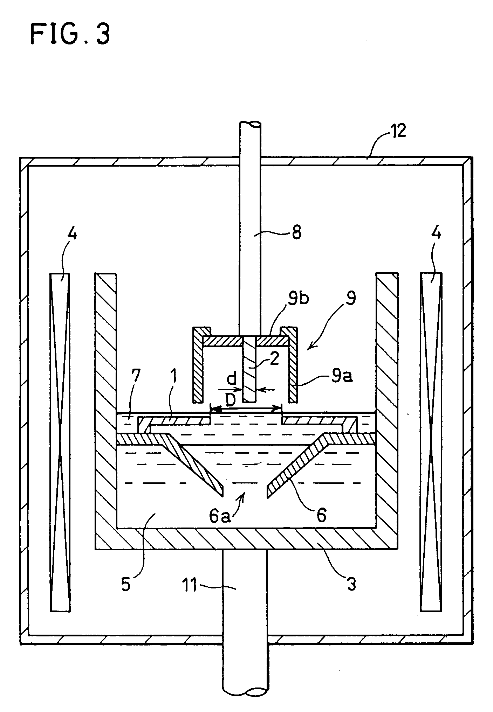

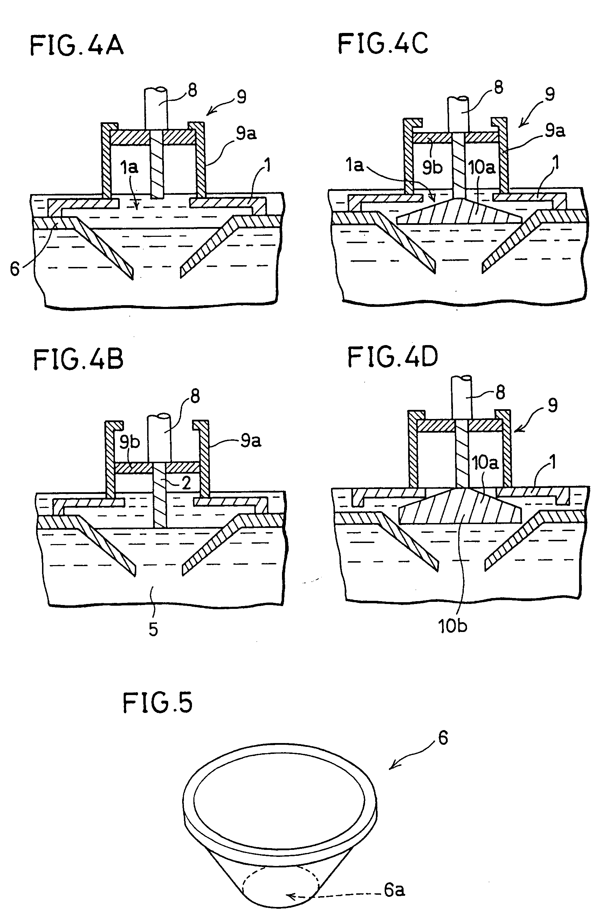

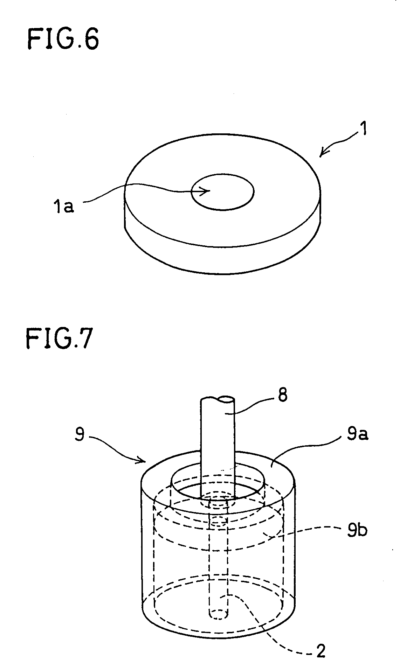

Fig. 3 schematically shows an apparatus for manufacturing a single crystal used in the first embodiment. Fig. 4 shows the manner of forming a single crystal by using the apparatus of Fig. 3. Referring to Fig. 3, in this apparatus, a crucible 3 containing raw material molten solution 5 is provided rotatably supported by a lower shaft 11 in a chamber 12. A heater 4 is arranged around the crucible 3. A coracle 6 is provided to float on the raw material molten solution 5. Coracle 6 has a communicating hole 6a at the bottom portion, and the raw material molten solution 5 is introduced therein. A ring-shaped first radiation intercepting member (hereinafter simply referred to as a first member) is mounted on coracle 6 to keep the temperature of the raw material molten solution in coracle 6. Figs. 5 and 6 show coracle 6 and the first member 1, respectively. Coracle 6 is an inverted conical molding body having a communication hole 6a at the bottom. The first member is a disk-shaped molding body having an opening 1a at the center. The surface of raw material molten solution 5 is covered with a liquid encapsulant 7. A rotatable/vertically movable upper shaft 8 for pulling the crystal is provided above the central portion of the crucible 3. In the apparatus structured as described above, a seed crystal 2 as well as a second radiation intercepting member (hereinafter simply referred to as a second member) 9 are attached at the lower end of upper shaft 8. The second member 9 has a disk-shaped radiation intercepting plate 9b movable in the manner of a piston, provided at a cylindrical radiation intercepting cylinder 9a, as shown in Figs. 3 and 7. The lower end of upper shaft 8 and seed crystal 2 are attached at the central portion of radiation intercepting plate 9b.

In the apparatus for manufacturing a single crystal, the gap (D-d)/2 provided when the seed crystal is passed through the opening may be 2 to 20mm and preferably in the range of 4 to 10mm where D represents the diameter of the opening of the first member 1 and d represents the diameter of the seed crystal. With the gap within such range, the seed crystal can be passed through the opening smooth, while heat radiation from the opening is minimized.

The steps of forming a single crystal by using the above described apparatus will be described. Raw material molten solution 5 and liquid encapsulant 7 are contained in crucible 3, and the temperature of the raw material molten solution is controlled by means of heater 4. With the coracle 6 dipped in raw material molten solution 5, the first member 1 is placed on coracle 6. At this time, coracle 6 as well as the first member 1 floats on the raw material molten solution 5, since the coracle is adjusted to have an appropriate buoyancy. The coracle 6 which is floating is filled with the raw material molten solution, and the surface of the molten solution has an appropriate diameter. When upper shaft 8 is lowered to lower the seed crystal 2 and the second member 9 in this state, radiation intercepting cylinder 9a of the second member 9 is placed on the first member 1 at first, as shown in Fig. 4A. At this state, the opening 1a of the first member is covered by the second member 9. In this manner, radiation from the raw material molten solution through the opening 1a in coracle 6 is intercepted. When the upper shaft is further lowered with the radiation intercepted, the radiation intercepting plate 9b slides in radiation intercepting cylinder 9a and lowers in the second member 9, and the seed crystal 2 is dipped in raw material molten solution 5 as shown in Fig. 4B. After seeding, upper shaft 8 is elevated while it is rotated, and a shoulder portion 10a of the single crystal is formed as shown in Fig. 4C. From seeding to the formation of the shoulder portion, the second member 9 is kept placed on the first member 1. In addition, radiation intercepting plate 9b slides in radiation intercepting cylinder 9a, and therefore the opening 1a of the first member 1 is kept covered by the second member 9. Namely, seeding is done with radiation from the opening of the coracle sufficiently suppressed, and then the single crystal is pulled. When upper shaft 8 is further elevated, the first member 1 is positioned on the shoulder portion 10a of the single crystal formed, and the second member 9 is placed further thereon, in which state the cylindrical body portion 10b of the single crystal is formed. In this manner, seeding and formation of the shoulder portion are carried out with the entire surface of the raw material molten solution covered by the first and second members, the single crystal can be formed with high reproducibility, preventing generation of polycrystal and twins, and the rapid growth of the crystal after seeding can be prevented.

A GaAs single crystal was grown with the temperature gradient in the direction of pulling being as small as 5 to 10°C/cm by using the apparatus shown in Fig. 3. The apparatus was designed such that the crucible 3 was formed by PBN having the diameter of 4 inch, the coracle 6 was formed by BN with the thickness of 10mm, and the diameter of the raw material molten solution contained therein was 55mm. The first member 1 had a disk-shape with a hole at the centre, the inner diameter of which is little larger than the diameter of the opening of coracle 6, and the member 1 was formed by carbon having the thickness of 5mm. The diameter of the opening of the first member 1 was 10mm. The second member 9 was formed of carbon having the thickness of 5mm, the diameter of radiation intercepting plate 9b was 90mm, the diameter of the upper opening of radiation intercepting cylinder 9a was 15mm and the length thereof was 40mm. 1.5kg of GaAs polycrystal and 200g of liquid encapsulant ($B_2O_3$) were charged in the crucible 3. A chamber 12 was pressurized to 10kg/cm$^2$ with Ar gas. A seed crystal 2 on GaAs ⟨ 100 ⟩ 4mm square and 39mm in length was attached at the lower end of upper shaft 8 through radiation intercepting plate 9b. The raw material polycrystal was heated and molten by heater 4. The upper shaft 8 is lowered so that the seed crystal 2 was dipped in the raw material molten solution, then temperature of the raw material molten solution is adjusted to be the temperature of crystal growth, and the single crystal was grown with the speed of pulling of the upper shaft 8 being 5mm/h, the rate of rotation of upper shaft 8 being 5rpm and the rate of rotation of lower shaft 11 being 10rpm. Consequently, a GaAs single crystal having the cone angle at the shoulder portion of 90°C, the diameter of the cylindrical body of 55mm and the length of 100mm was obtained. The dislocation density of the resulting single crystal was as low as 1000cm$^{-2}$ to 1500cm$^{-2}$, and it was proved that the crystal was superior with hardly no crystal defects. The single crystal could be pulled with the yield of 90%.

On the other hand, a crystal was grown with only the outer periphery of the raw material molten solution was kept warm by using the first member 1 only, under the same conditions as in the above described case. Consequently, rapid growth of the crystal was frequently occurred immediately after the seeding until the diameter became as large as 10mm, and twins were frequently generated immediately below the seed crystal. The yield of pulling the single crystal was lowered to 50%. From these results, it is proved that the method and an apparatus for manufacturing a single crystal in accordance with the present invention can significantly improved the production yield of the single crystal as compared with the prior art.

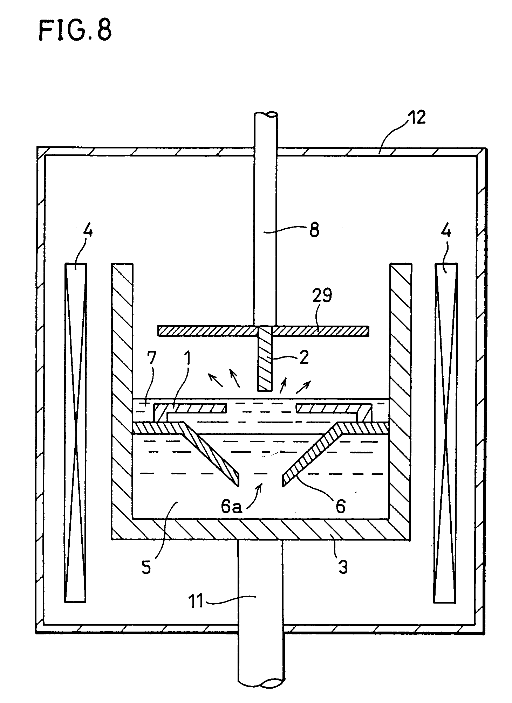

A member which covers the first member and capable of sufficiently suppressing heat radiation may be used as the second member described in the above embodiment. For example, out of the second member described in the embodiment, only the radiation intercepting plate can be used as the second member provided that the diameter of which is large enough. An example using the radiation intercepting plate only is shown in Fig. 8 as a second embodiment. As shown in the figure, the disk-shaped radiation intercepting plate 29 has a diameter large enough to intercept radiation (represented by arrows) through the opening of the first radiation intercepting member. In this apparatus, portions other than the radiation intercepting plate 29 are the same as those in the first embodiment.

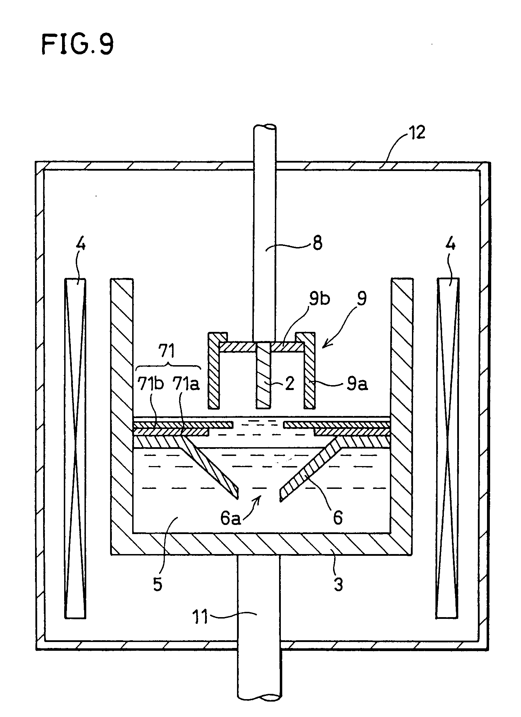

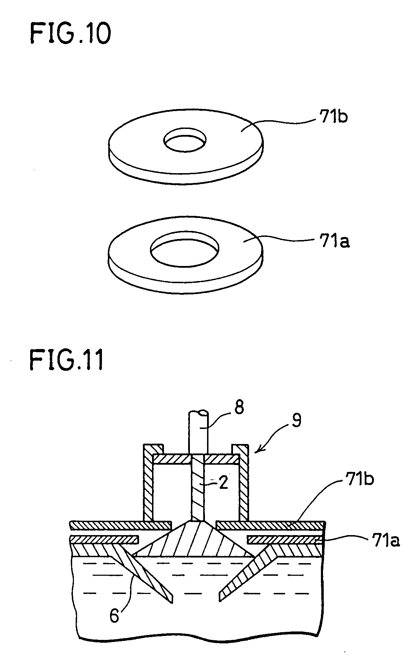

Various structures other than those described above may be employed as the radiation intercepting member of the present invention. A modification of the first radiation intercepting member is shown in Fig. 9 as a third embodiment. In this apparatus, the first radiation intercepting member 71 includes two disk-shaped members 71a and 71b having opening portions of different diameters. Fig. 10 is perspective view of these members. In this apparatus, disk-shaped member 71a having the opening portion of larger diameter is mounted on the coracle, and disk-shaped member 71b having the opening portion of smaller diameter is mounted thereon. When the members of such structure are used, first, disk-shaped member 71b is pulled when the shoulder portion of the crystal is formed, as shown in Fig. 11. At this time, the lower disk-shaped member 71a stays on the coracle 6, and therefore escape of heat because of radiation from the surface of the raw material molten solution which has not yet being crystallized can be effectively prevented. Thus rapid growth of the shoulder portion can be effectively prevented. Although two disk-shaped members were used in the above embodiment, the first radiation intercepting member may include three or more disk-shaped members.

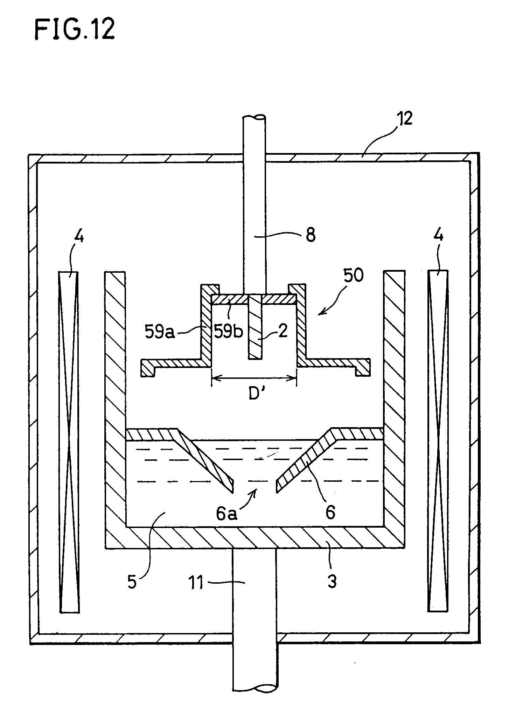

A radiation intercepting member having a structure in which the first radiation intercepting member and the second radiation intercepting member shown in the first embodiment are integrated is shown in Fig. 12 as a fourth embodiment. The radiation intercepting member 50 of this apparatus is placed on the coracle 6 when the upper shaft 8 is lowered. Then, when upper shaft 8 is further lowered, radiation intercepting plate 59b slides in radiation intercepting cylinder 59a as in the first embodiment. After the seeding carried out in the same manner as the first embodiment, the shoulder portion of the crystal is pulled. Radiation intercepting member 50 is pulled together with the grown crystal. The inner diameter D' of member 50 should be smaller, since radiation from the surface of the raw material molten solution can be more effectively intercepted when the inner diameter is smaller.

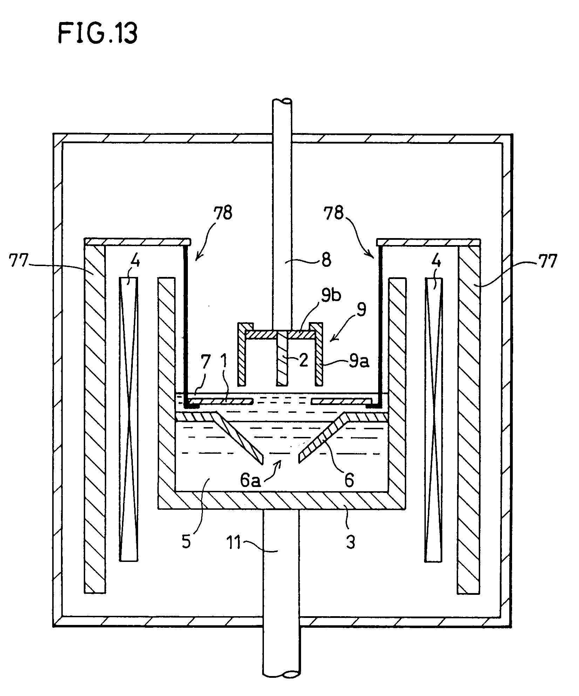

In the above described embodiments, the first radiation intercepting member was placed on the coracle. However, the coracle may be supported by other members. In the example shown in Fig. 13, the first member 1 is supported by a supporter 78 attached to a heat insulator 77 and provided above the coracle 6.

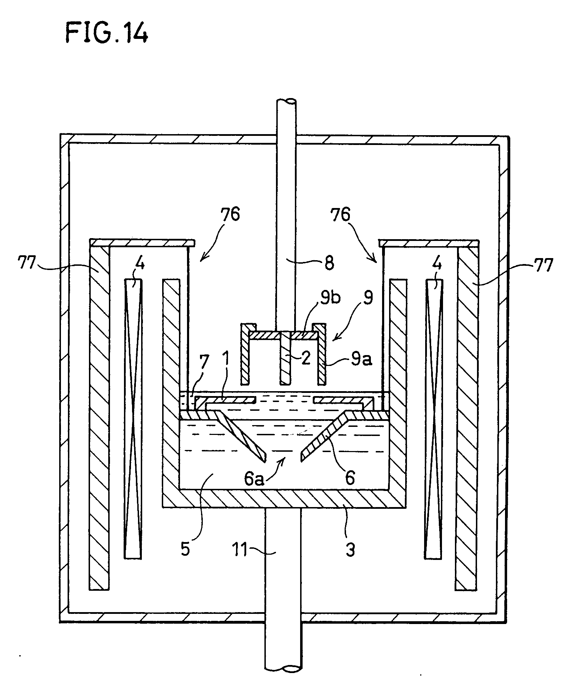

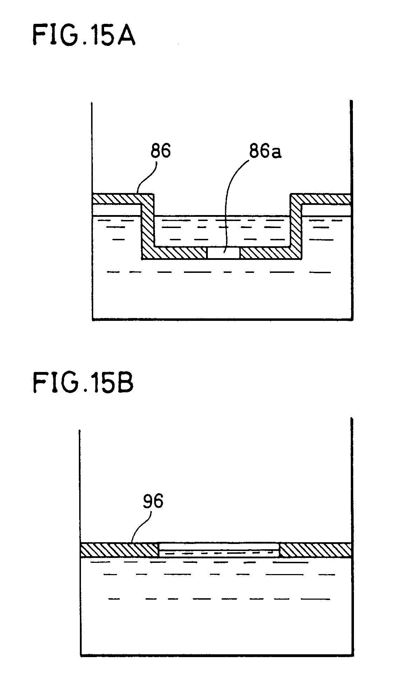

Although the coracle is not fixed but floating on the raw material molten solution in the crucible in the above embodiments, the coracle may be fixed on other members. Fig. 14 shows a fifth embodiment in which apparatus the coracle is fixed. In this apparatus, coracle 6 is fixed by a coracle supporter 76 on a heat insulator 77 provided around the crucible. In this apparatus, portion other than the mechanism for fixing the coracle are the same as those of the first embodiment. In this apparatus, the lower shaft 11 is rotatable and vertically movable. The diameter of the surface of the raw material molten solution flowing in the coracle 6 is adjusted by moving up and down the lower shaft. Although the coracle is fixed on the heat insulator in this apparatus, it may be fixed on other members, or it may be fixed on other members or it may be fixed on other member which is vertically movable. Any coracle having a structure capable of maintaining the surface of the raw material molten solution contained therein at a prescribed size may be used, and a coracle such as shown in Fig. 15A or Fig. 15B may be used in place of the structures described above. The coracle 86 shown in Fig. 15A takes the molten solution from the communicating hole 86a and keeps the molten solution in a cylindrical shape. The coracle 96 of Fig. 15B is a ring-shaped disk. Further, if the crystal is to be grown without rotation, a coracle may be used the cross section of the molten solution contained in that coracle is polygonal or elliptical.

Although the surface of the raw material molten solution was covered with a liquid encapsulant in the above described embodiments, liquid encapsulant may not be used dependent on the material of the crystal or the method of growth.

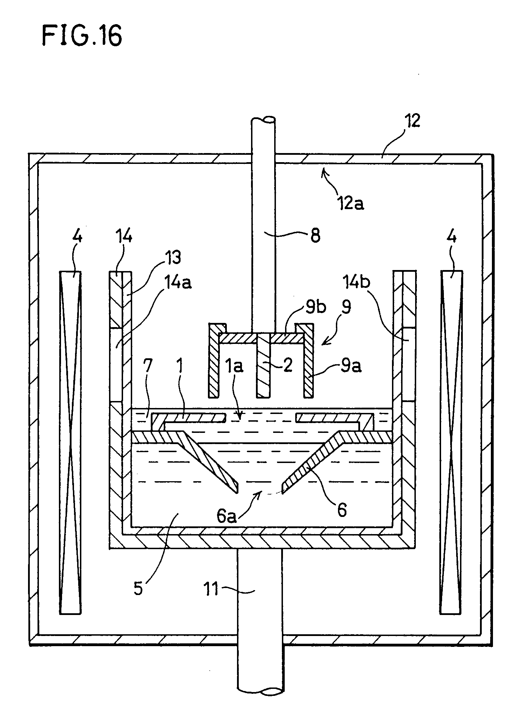

A sixth embodiment in accordance with the present invention will be described. Fig. 16 schematically shows an apparatus for manufacturing a single crystal used in the sixth embodiment. In this apparatus, a crucible 14 is provided supported by a rotatable lower shaft 11 in a chamber 12. A quartz crucible 13 for containing the raw material molten solution 5 is provided in the crucible 14. In the quartz crucible 13, a coracle 6 is provided floating on the raw material molten solution 5. The coracle 6 has a communication hole 6a at the bottom thereof, and the raw material molten solution 5 is introduced therein. Portions above the surface of the raw material molten solution 5 of crucible 14 is removed to provide a pair of windows 14a and 14b, through which quartz crucible 13 can be seen. A ring-shaped first radiation intercepting member (hereinafter simply referred to as the first member) 1 is placed on coracle 6 so as to keep the temperature of the raw material molten solution in coracle 6. The shapes of the coracle and of the first member 1 are as shown in Figs. 5 and 6. A rotatable and vertically movable upper shaft 8 is provided above the central portion of crucible 13. The surface of raw material molten solution 5 is covered with liquid encapsulant 7. A seed crystal 2 as well as a second radiation intercepting member (hereinafter simply referred to as the second member) 9 are attached at the lower end of upper shaft 8. The second member 9 has a structure including a disk-shaped radiation intercepting plate 9b movable like a piston in a cylindrical radiation intercepting cylinder 9a. Upper shaft 8 and seed crystal 2 are attached at the central portion of the radiation intercepting plate 9b.

The steps for forming a single crystal by using such a device will be described in the following. Raw material molten solution 5 and liquid encapsulant 7 are contained in crucible 13, and the temperature is controlled by means of a heater 4. While the coracle 6 is dipped in raw material molten solution 5, the first member 1 is placed on coracle 6. At this time, coracle 6 together with the first member 1 float on raw material molten solution adjusted by an appropriate buoyancy. Raw material molten solution is filled in coracle 6 which is floating, and the surface of the molten solution has an appropriate diameter. Through the windows 14a and 14b formed at crucible 14, radiation from the heater passes the quartz crucible 13. Therefore, the surface of and above the raw material molten solution 5 are heated by this radiation. When upper shaft 8 is lowered so as to lower the seed crystal 2 and the second member 9 in this state, at first radiation intercepting cylinder 9a of the second member 9 is placed on the first member 1 as shown in Fig. 4A, in the same manner as in the first embodiment. In this state, the opening 1a of the first member is covered by the second member 9. Since the opening is covered in this manner and radiation from the heater reaches above the surface of the raw material molten solution, heat radiation from the raw material molten solution in coracle 6 through the opening 1a can be suppressed. When upper shaft 8 is further lowered with heat radiation suppressed, radiation intercepting plate 9b lowers sliding in the radiation intercepting cylinder 9a of the second member 9. The seed crystal 2 is dipped in raw material molten solution 5, as shown in Fig. 4B. After seeding, when the upper shaft is elevated while it is rotated, a shoulder portion 10a of the single crystal is formed as shown in Fig. 4C. From the step of seeding to the step of forming the shoulder portion, the second member 9 is kept placed on the first member 1. In addition, radiation intercepting plate 9b slides in the radiation intercepting cylinder 9a, and the opening 1a of the first member 1 is kept covered by the second member 9. Therefore, seeding is carried out and the single crystal is pulled with heat radiation from opening 1a suppressed. When the upper shaft 8 is further elevated, the first member is placed on the shoulder portion 10a of the grown single crystal with the second member 9 placed further thereon, and the cylindrical body portion 10b of the single crystal is formed as shown in Fig. 4D.

By using the apparatus shown in Fig. 16, a GaAs single crystal was grown with the temperature gradient in the direction of pulling near the molten solution as small as 5 to 10°C/cm. The temperature of the upper surface 12a of chamber 2 was as low as about 100°C. In the apparatus, the crucible 13 had the diameter of 10.2 cm (4 inch) and was formed of quartz, and the outer crucible 14 was formed of carbon. Eight circular windows having the diameter of 30mm were formed at portions of the crucible 14 which portion was above the molten solution. The coracle 6 was formed of BN having the thickness of 10mm and the coracle was designed such that the surface of the raw material molten solution contained therein would be 55mm. The first member 1 had a hollow disk-shapes the diameter of which is little larger than the diameter of the opening of coracle 6. The first member was formed of carbon having the thickness of 5mm. The diameter of the hole was 10mm. The second member 9 was formed of carbon having the thickness of 5mm. The diameter of the heat insulating plate 9b was 20mm, the diameter of the upper opening of the heat insulating cylinder 9a was 15mm, and the length of the cylinder was 40mm. 1.5kg. of GaAs polycrystal and 200g of liquid encapsulant ($B_2O_3$) were charged in the crucible 13, and the chamber 12 was pressurized to 10kg/cm$^2$ with Ar gas. A seed crystal 2 of GaAs 〈 100 〉 which was 4mm square and 40mm in length is attached on the lower end of upper shaft 8 through radiation intercepting plate 9b. The raw material polycrystal was heated and molten by heater 4. The seed crystal is dipped in raw material molten solution by lowering upper shaft 8, and then the temperature of the raw material molten solution was adjusted to be the temperature of crystal growth. A single crystal was grown with the rate of pulling of upper shaft 8 being 5mm/hr, the rate of rotation of upper shaft 8 being 5rpm, and rate of rotation of lower shaft 11 being 10rpm. Consequently, a GaAs single crystal was grown which had the cone angle of the shoulder portion of 100°, the diameter of the cylindrical body portion of 55mm and the length of 120mm. The dislocation density of the resulting single crystal was as low as 1000cm$^{-2}$ to 1500cm$^{-2}$, and it was proved to be a superior crystal with hardly no crystal defect. The single crystal can be pulled with the yield of 85%.

On the other hand, an experiment of crystal growth was carried out by using an apparatus in which the crucible was formed of carbon which is opaque and not transmitting the radiation from the heater. Since the temperature of the upper surface of the chamber was as low as about 200°C, much heat escaped because of radiation from the raw material molten solution. Consequently, rapid growth of the crystal frequently occurred immediately after the seeding until the diameter became as large as 10mm, and twins were frequently generated immediately below the seed crystal. The production yield of pulling the single crystal was lowered to 60%.

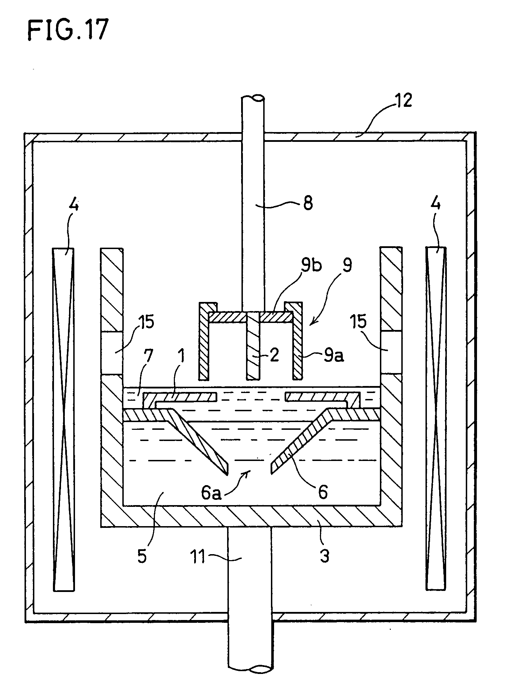

Means for letting radiation from the heater reach the upper surface of and above the raw material molten solution may have various structures. A modification of this means is shown as a seventh embodiment. Referring to Fig. 17, in this apparatus, a portion of the crucible 3 which is above the raw material molten solution 5 and liquid encapsulant 7 is partially removed to provide window 15 of appropriate size. Other structures are the same as in the apparatus of Fig. 16. In this example, the heat ray from heater 4 is directly radiated to the surface of the raw material molten solution and to the radiation intercepting member through the windows 15.

The first and second radiation intercepting members shown in the sixth and seventh embodiments may be modified as shown in the second, third and the fourth embodiments. Further, the coracle may be fixed as shown in the fifth embodiment. Although the surface of the raw material molten solution was covered with a liquid encapsulant, the liquid encapsulant may not be used dependent on the material of the crystal or on the method of growth.

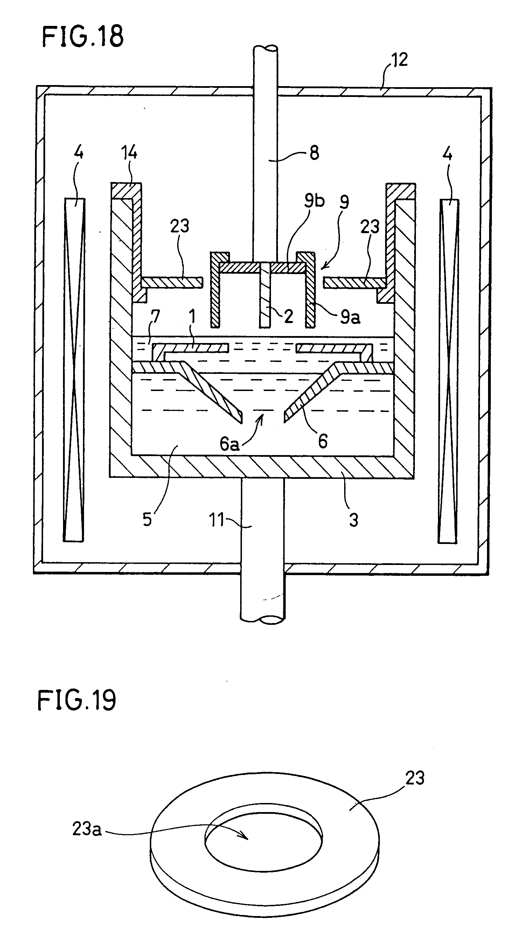

An eighth embodiment of the present invention will be described in the following. Fig. 18 schematically shows an apparatus for manufacturing a single crystal used in the eighth embodiment. In this apparatus, a crucible 3 containing the raw material molten solution is provided supported by a rotatable lower shaft in a chamber 12, and a heater 4 is provided around the crucible 3. A coracle 6 is provided floating on the liquid crystal molten solution 5 in crucible 3. The coracle 6 has a communicating hole 6a at the bottom portion, and the raw material molten solution 5 is introduced therein. A ring-shaped first radiation intercepting member (hereinafter referred to as a first member) 1 is mounted on the coracle 6 so as to keep the temperature of the raw material molten solution in coracle 6. The shapes of the coracle and of the first member are as shown in Figs. 5 and 6. The surface of the raw material molten solution is covered with a liquid encapsulant 7. A rotatable and vertically movable upper shaft 8 is provided above the central portion of the crucible 3. In the apparatus structured as described above, a seed crystal 2 as well as a second radiation intercepting member (hereinafter referred to as a second member) 9 are attached at the lower end of upper shaft 8. As described above, the second member 9 has a structure including a disk-shaped radiation intercepting plate 9b movable like a piston in a cylindrical radiation intercepting cylinder 9a. At the center of the radiation intercepting plate 9b, the lower end of upper shaft 8 and the seed crystal 2 are attached. A hollow disk-shaped third radiation intercepting member (hereinafter referred to as a third member) 23 is provided above the first member 1 by means of a supporter put across the upper end of the crucible 3. The third member 23 includes a circular hole 23a through which the upper shaft 8 and second member 9 are passed. The third member 23 covers the upper portion of coracle 6 as shown in the figure.

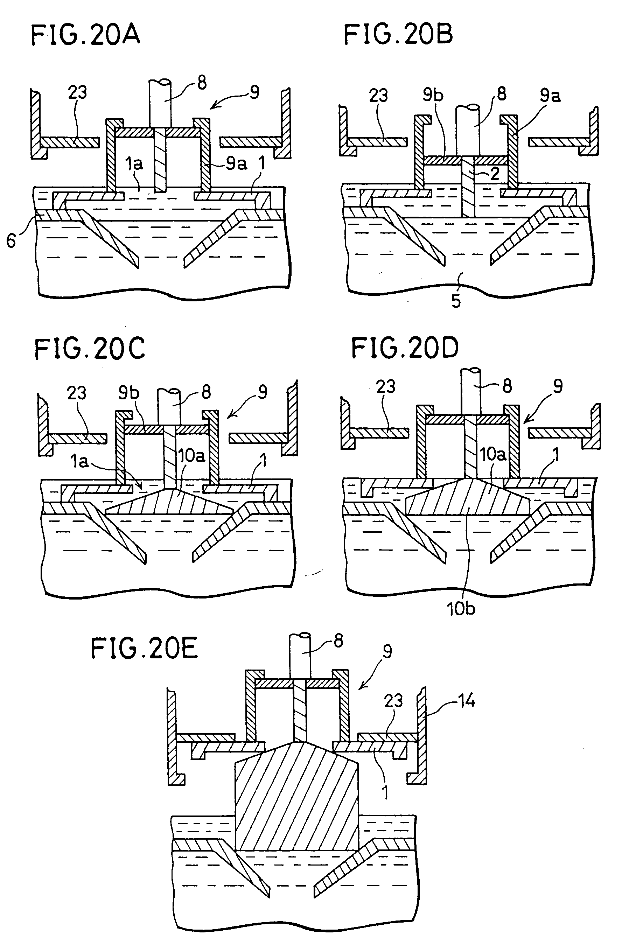

The steps for growing a single crystal by using such an apparatus will be described in the following. The raw material molten solution 5 and the liquid encapsulant 7 are contained in the crucible and the temperature is controlled by heater 4. While the coracle 6 is dipped in the raw material molten solution 5, the first member 1 is placed on the coracle 6. At this time, since the coracle 6 is adjusted to have an appropriate buoyancy, it floats together with the first member 1 on the raw material molten solution 5. The raw material molten solution is filled in the coracle 6 which is floating, and the surface of the molten solution has an appropriate diameter. At this state, most of the radiation from the raw material molten solution can be intercepted by the first member 1 and the third member 23. When the upper shaft 8 is lowered so as to lower the seed crystal 2 and the second member 9, the radiation intercepting cylinder 9a of the second member 9 is, at first, placed on the first member 1 as shown in Fig. 20A. In this state, the opening 1a of the first member is covered by the second member 9. Since the opening is covered in this manner, radiation through the opening 1a from the raw material molten solution in coracle 6 can be intercepted. In this manner, the surface of the raw material molten solution is entirely covered by the first and second members, and above the first member, covered by the third member. Emission of heat from the surface of the raw material molten solution can be suppressed by the first and second members. Further, the first member is covered by the third member, and the second member can be moved below the third member through the opening 23a. Consequently, emission of heat from the first and second members can be suppressed by the third member. When upper shaft 8 is further lowered with heat radiation suppressed, the radiation interrupting plate 9b lowers sliding in the radiation intercepting cylinder 9a in the second member. The seed crystal 2 is dipped in the raw material molten solution 5 as shown in Fig. 20B. After seeding, when the upper shaft 8 is elevated while it is rotated, a shoulder portion 10a is formed as shown in Fig. 20C. From the step of seeding to the step of forming the shoulder portion, the second member 9 is kept placed on the first member 1. In addition, since the radiation intercepting plate 9b slides in the radiation intercepting cylinder 9a, the opening 1a of the first member 1 is kept covered by the second member 9. Therefore, seeding is done and the single crystal is pulled with heat radiation from the opening 1a suppressed. When the upper shaft 8 is further elevated, the first member 1 is placed on the shoulder portion 10a of the grown single crystal, and the second member 9 is placed further thereon while the cylindrical body portion 10b of the single crystal is formed. When the upper shaft 8 is further elevated, the third member 23 is pulled together with the single crystal, placed on the first member 1, as shown in Fig. 20E. In this manner, heat radiation from the opening 1a of the first member is suppressed by the second member, the temperature of the raw material molten solution is kept by the double members, that is, the first and third members, and the single crystal is pulled in this condition. Therefore, rapid growth of the crystal at the start of pulling can be prevented, and hence generation of polycrystal and twins can be prevented. Consequently, a single crystal can be grown with high reproducibility.

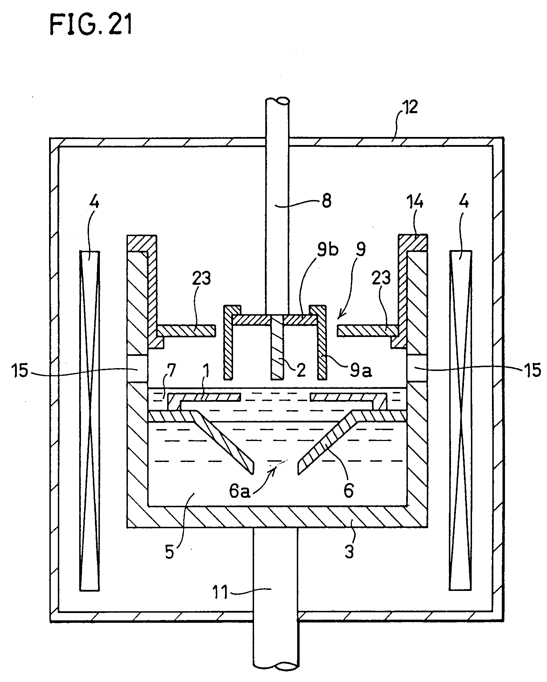

A ninth embodiment of the present invention will be described. In the ninth embodiment, an apparatus shown in Fig. 21 was used. This apparatus differs from the apparatus of Fig. 8 in that the crucible 3 has a different structure. In this apparatus, windows 15 are formed at a portions of the crucible 3 which are above the liquid surface of the liquid encapsulant 7. As described above, the window 15 may be open or an appropriate material which transmits radiation heat easily may be fitted therein. In this apparatus, the portions other than the crucible are the same as those in the apparatus of Fig. 18. In this apparatus, heat ray from the heater 4 is radiated in the crucible through the windows 15. The heat ray is radiated in the space between the raw material molten solution and the third member, and to the surface of the raw material molten solution. By this radiation heat, the effect of keeping the temperature provided by the first, second and third members can be further improved. The steps for forming the single crystal in this apparatus are the same as those of the eighth embodiment.

A crystal of CdTe was formed by using the apparatus of Fig. 21. In this apparatus, the crucible was formed of carbon and had a diameter of 10,2 cm (4 inch). Quartz was fitted in the window 15. The coracle 6 is formed of carbon having the thickness of 10mm, and it is adapted such that the diameter of the raw material molten solution contained therein would be 55mm. The first member 1 had a hollow disk-shape with the diameter a little larger than the diameter of the opening of coracle 6, and the first member 1 was formed of carbon having the thickness of 5mm. The diameter of the hole was 10mm. The second member 9 was formed of carbon to have the thickness of 5mm. The diameter of the radiation intercepting plate 9b was 15mm. The diameter of the opening of the radiation intercepting cylinder 9a was 20mm, and the length thereof was 40mm. The third member 23 was formed of carbon to have the thickness of 5mm. The diameter of the opening was about 30mm. 1.5kg of CdTe polycrystal and 200g of liquid encapsulant ($B_2O_3$) were charged in the crucible 3. The chamber 12 was pressurized to 20kg/cm$^2$ with Ar gas. A seed crystal 2 of CdTe (100) of 4mm square and 30mm in length is attached to the lower end of the upper shaft 8 through the radiation intercepting plate 9b. The raw material polycrystal was heated and molten by heater 4. The upper shaft 8 was lowered to dip the seed crystal 2 in the raw material molten solution, and thereafter the temperature of the raw material molten solution was adjusted to the temperature of crystal growth. The single crystal was grown with the rate of pulling of the upper shaft 8 being 2mm/hr, the rate of rotation of the upper shaft 8 being 5rpm and the rate of rotation of the lower shaft 11 being 5rpm. Consequently, a CdTe single crystal having the cone angle of the shoulder portion of 150°, the diameter of the cylindrical body of 55mm and the length 80mm was grown. The dislocation density of the resulting single crystal was as low as 5000cm$^{-2}$ to 50000cm$^{-2}$, and the crystal was proved to be a superior crystal. The single crystal could be pulled at the yield of 75%.

On the other hand, a crystal was grown with the temperature of the raw material molten solution kept by the first member 1 only and other conditions being the same as described above. Consequently, rapid growth of crystal tended to occur immediately after the seeding until the diameter became 20mm, and twins were frequently generated immediately below the seed crystal. The yield of pulling the single crystal was lowered to 5%.

The first and second radiation intercepting members described in the eighth and ninth embodiments may be modified as shown in the second, the third and the fourth embodiments. The coracle may be fixed as described in the fifth embodiment. Although the surface of the raw material molten solution was covered with a liquid encapsulant in the above described embodiments, the liquid encapsulant may not be used dependent on the material to be grown or dependent on the method of growth.

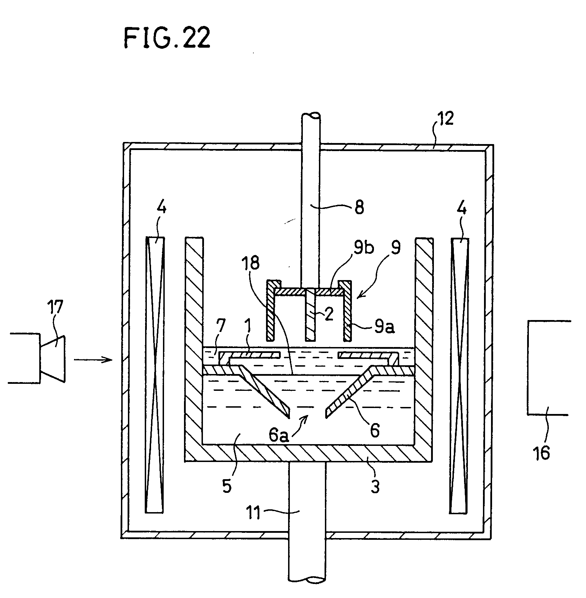

A tenth embodiment in accordance with the present invention will be described in the following. Fig. 22 is a schematic diagram of the apparatus used in the tenth embodiment. The apparatus includes an apparatus for obtaining an X-ray image in addition to the apparatus of the first embodiment. More specifically, an X-ray tube 17 for generating the X-ray and an X-ray imaging system 16 for forming an image by detecting the X-ray are provided outside the chamber 12. In the X-ray tube 17, the outlet of the X-ray is directed to the crucible 3 in the chamber 12. The portion for detecting the X-ray (not shown) of the X-ray imaging system is provided opposing the outlet of the X-ray on the other side of the crucible 3. The X-ray emitted from the X-ray tube 17 enters the chamber 12, passes through the crucible 3 and reaches the X-ray imaging system 16. By the provision of such apparatus, the X-ray image in the crucible 3 can be provided. In this apparatus, portions other than the X-ray tube 17 and the X-ray imaging system 16 are substantially the same in structure as the apparatus of the first embodiment.

A CdTe single crystal was grown by using the apparatus shown in Fig. 22. The crucible 3 was formed of quartz coated with carbon, and its diameter was 10,2 cm (4 inch). The coracle 6 was formed of carbon having the thickness of 10mm, and it was designed such that the diameter of the raw material molten solution contained therein would be 52mm. The coracle 6 had an appropriate specific gravity so that it floated on the raw material molten solution. The first member 1 had a hollow disk-shaped the diameter of which was a little larger than the diameter of the opening of coracle 6. The member 1 was formed of carbon to have the thickness of 5mm, and the diameter of the opening was 20mm. The second member 9 including the radiation intercepting cylinder 9a and the radiation intercepting plate 9b was formed of carbon. The thickness of the radiation interrupting cylinder 9a was 5mm, the diameter was 30mm and the length was 50mm. The thickness of the radiation intercepting plate 9b was 5mm. A CdTe single crystal cut in the direction of (111) having the dimension of 4mm square and 30mm in length was used as the seed crystal 2. 1.0kg of CdTe polycrystal and 100g of liquid encapsulant ($B_2O_3$) were charged in the crucible 3. The chamber 12 was filled with Ar gas so that the pressure was 15kg/cm$^2$. The material polycrystal was heated and molten by heater 4, and the upper shaft 8 was lowered so that the seed crystal was brought into contact with the raw material molten solution. After the seed crystal was in contact with the raw material molten solution, the temperature of the raw material molten solution was adjusted to be the temperature of crystal growth. Then, the single crystal was grown with the rate of pulling the upper shaft 8 being 3mm/hr, the rate of rotation of the upper shaft 8 being 5rpm, and the rate of rotation of the lower shaft 11 being 10rpm. The steps from seeding to pulling were monitored by the X-ray imaging system. At this time, the voltage of the X-ray tube was 150kV, and the current was 5mA. The target for emitting the X-ray was Mo. As a result of the above described operation, a CdTe single crystal having the diameter of the cylindrical body portion of 52mm and the length of 100mm was obtained. The yield of pulling the single crystal was 60%.

On the other hand, a single crystal was tried to be pulled without using the first and second members, under the same conditions as above. However, the CdTe single crystal could not be grown.

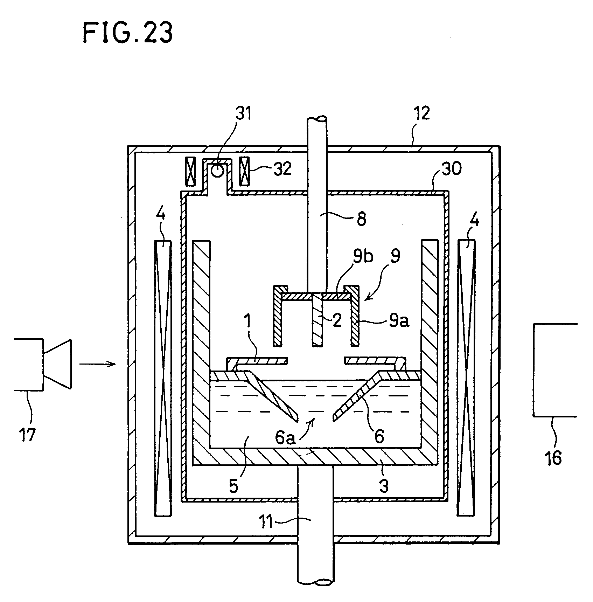

An eleventh embodiment of the present invention will be described in the following. Fig. 23 schematically shows the apparatus used in the apparatus of the eleventh embodiment. Referring to Fig. 23, the apparatus includes an air-tight container 30 surrounding the crucible and the space for pulling the crystal above the crucible, in addition to the apparatus of the tenth embodiment. The upper shaft 8 and the lower shaft 11 are passed to the air tight container 30 with the air-tight state is kept. A volatile constituent reservoir 31 is formed above the air-tight container 30. A heater 32 is provided around the volatile constituent reservoir 31. Although portions for passing the upper and lower shafts are not shown in the figure, a general structure employing a liquid encapsulant is employed.

A CdTe single crystal was grown by using the apparatus shown in Fig. 23. The air-tight container 30 was formed of carbon coated with PBN. The seed crystal used was the same as that of the tenth embodiment. Portions of the apparatus were designed similar to those of the apparatus of the tenth embodiment except the air-tight container. 1.0kg of CdTe polycrystal is charged, and Cd is filled in the volatile constituent reservoir 31. The temperature of heater 32 was increased to 900°C, and Cd was filled in the air-tight container 30 to have the pressure of about 3 bar (3atm). The chamber 12 was pressurized with Ar gas accordant with the pressure of Cd in the air-tight container 30. The single crystal was pulled under the same condition as in the tenth embodiment. As a result, CdTe single crystal could be grown with the yield of 65%.

The apparatus for obtaining the X-ray image disclosed in the tenth and the eleventh embodiments can be provided for the apparatuses shown in the second to ninth embodiments. By providing such apparatus, it becomes possible to monitor the steps of seeding to the growth of the single crystal also in the second to ninth embodiments. The air-tight container disclosed in the eleventh embodiment may be provided for the apparatuses of the second to ninth embodiments as well. When the air-tight container is used in the second to ninth embodiments, the single crystal can be grown in accordance with the Czochralski method controlling vapor pressure of volatile constituent.

As described above, by the present invention, from seeding to the formation of the shoulder portion of the single crystal in accordance with the Czochralski method, radiation from the surface of the raw material molten solution to the above can be substantially intercepted. Therefore, in the method or apparatus of the present invention, the rapid growth of the crystal at the start of pulling can be sufficiently suppressed when the temperature gradient in the direction of pulling is small. Further, even when a crystal of a material having low thermal conductivity (for example, CdTe) is to be pulled, the rapid growth of the crystal at pulling of the crystal can be sufficiently suppressed. Consequently, generation of polycrystal and twins can be prevented. Therefore, by the method or apparatus of the present invention, a crystal having low dislocation density can be pulled. In addition, by controlling the diameter of the crystal to be grown by means of a coracle, a single crystal having smooth shoulder portion can be grown. Further, by obtaining an X-ray image in the crucible by emitting X-ray to the crucible, the manner of pulling of the single crystal can be monitored, and accordingly, the shape of the single crystal being pulled can be effectively controlled. This invention provides a method and apparatus enabling manufacturing of a single crystal with high production yield when the temperature gradient in the direction of pulling is small or when the thermal conductivity of the crystal to be grown is small.

## Claims

1. A method of manufacturing a single crystal by bringing into contact a seed crystal attached at a lower end of a crystal pulling shaft with a raw material molten solution and thereafter by pulling said seed crystal by said crystal pulling shaft, comprising:

   the step of providing in said raw material molten solution a coracle having an opening capable of containing therein said raw material molten solution such that the surface of said raw material molten solution has a prescribed size;

EP 0 509 312 B1

the first step of intercepting radiation by providing a first member having an opening through which the seed crystal is passed, on said coracle to cover the surface of said raw material molten solution in said coracle for intercepting radiation above said coracle from said raw material molten solution;

the second step of intercepting radiation by covering said opening with a second member supported by said crystal pulling shaft when said seed crystal is brought into contact with said raw material molten solution for intercepting said radiation through said opening;

the step of seeding in which said radiation is intercepted by said first member and said second member and said crystal pulling shaft is lowered to bring into contact said seed crystal with said raw material molten solution;

the step of forming a shoulder portion of a single crystal by intercepting said radiation by said first member and said second member after said step of seeding while elevating said crystal pulling shaft; and

the step of forming a cylindrical body portion of the single crystal by elevating said crystal pulling shaft together with said first member after said step of forming the shoulder portion while forming the single crystal from the raw material molten solution in said coracle.

2. The method of manufacturing a single crystal according to claim 1, wherein from said first step of intercepting radiation to said step of forming the shoulder portion, said radiation is further intercepted by covering said first member by a third member having an opening through which said second member is passed, provided above said first member.

3. The method according to claim 1, wherein
(D-d)/2 is within the range of 2 to 20mm, where D denotes the diameter of the opening of said first member and d denotes the diameter of the seed crystal.

4. The method according to claim 1, wherein
said first member covers said raw material molten solution within 50mm above said raw material molten solution.

5. The method according to claim 1, wherein
said first member and said second member are integrated.

6. The method of manufacturing a single crystal according to claim 1, wherein
a liquid encapsulant is provided on said raw material molten solution.

7. The method of manufacturing a single crystal according to claim 1, wherein
radiation from a heat source is given to the surface of and above said raw material molten solution from said first step of intercepting radiation to said step of forming the shoulder portion.

8. The method of manufacturing a single crystal according to claim 1, wherein
pulling of said single crystal is carried out in an atmosphere including volatile constituent.

9. The method of manufacturing a single crystal according to claim 1, wherein
said raw material molten solution is for forming a CdTe crystal.

10. An apparatus for manufacturing a single crystal, comprising:
a crucible (3) for containing a raw material molten solution (5);
a lower shaft (11) for supporting said crucible;
a heater (4) arranged around said crucible;
a coracle (6) provided in said crucible and having an opening capable of containing therein said raw material molten solution such that the surface of said raw material molten solution has a prescribed size;
a rotatable and vertically movable upper shaft (8), for pulling a single crystal from said raw material molten solution;
a first radiation intercepting member (1) having an opening (1a) at the central portion, provided movable on said coracle and covering the surface of said raw material molten solution for intercepting radiation from the raw material molten solution in said coracle to the above; and
a second radiation intercepting member (9) supported by said upper shaft and covering said

14

opening for intercepting said radiation through the opening of said first radiation intercepting member.

11. The apparatus for manufacturing a single crystal according to claim 10, further comprising
a third radiation intercepting member (23) having an opening through which said second radiation intercepting member is passed, covering said first radiation intercepting member for further intercepting said radiation above said first radiation intercepting member.

12. The apparatus for manufacturing a single crystal according to claim 10, wherein
said first radiation intercepting member and said second radiation intercepting member are integrated.

13. The apparatus according to claim 10, wherein
said first radiation intercepting member (71) is formed by stacking a plurality of disk-shaped members (71a, 71b) having openings of different diameters.

14. The apparatus according to claim 10, wherein
(D-d)/2 is within the range of 2 to 20mm where D denotes the diameter of the opening of said first radiation intercepting member and d denotes the diameter of a seed crystal.

15. The apparatus for manufacturing a single crystal according to claim 10, further comprising
an air-tight container (30) surrounding the crucible and the space for pulling the crystal above the crucible for pulling said single crystal in an atmosphere of a volatile constituent.

16. The apparatus for manufacturing a single crystal according to claim 10, further comprising
means (15) for letting radiation from said heater to reach the surface of and above said raw material molten solution.

17. The apparatus for manufacturing a single crystal according to claim 16, wherein
said means is a window (15) formed at an upper portion of said crucible for taking radiation from said heater.

**Patentansprüche**

1. Verfahren zur Herstellung eines Einkristalls durch Inkontaktbringen eines Impfkristalls, der an einem unteren Ende eines Kristallzugschaftes befestigt ist, mit einer Rohmaterial-Schmelzlösung und danach Herausziehen des Impfkristalls mit dem Kristallzugschaft, umfassend:
den Schritt des Vorsehens eines Einsatztiegels in der Rohmaterial-Schmelzlösung mit einer Öffnung, die in der Lage ist, darin die Rohmaterial-Schmelzlösung so aufzunehmen, daß die Oberfläche der Rohmaterial-Schmelzlösung eine vorgegebene Größe aufweist;
den ersten Schritt des Abfangens von Strahlung durch Vorsehen eines ersten Elementes mit einer Öffnung, durch welche der Impfkristall hindurchgeht, auf dem Einsatztiegel zum Abdecken der Oberfläche der Rohmaterial-Schmelzlösung in dem Einsatztiegel, um die Strahlung von der Rohmaterial-Schmelzlösung über dem Einsatztiegel abzufangen;
der zweite Schritt zum Abfangen von Strahlung durch Abdeckung der Öffnung mit einem zweiten Element, das durch den Kristallzugschaft gehalten wird, wenn der Impfkristall in Kontakt mit der Rohmaterial-Schmelzlösung gebracht wird, zum Abfangen der Strahlung durch die Öffnung;
den Schritt des Aufwachsens, in welcher die Strahlung durch das erste Element und das zweite Element abgefangen wird und der Kristallzugschaft abgesenkt wird, um den Impfkristall mit der Rohmaterial-Schmelzlösung in Kontakt zu bringen,
den Schritt des Bildens eines Schulterteiles eines Einkristalls durch Abfangen der Strahlung durch das erste Teil und das zweite Teil nach dem Schritt des Aufwachsens, während der Kristallzugschaft angehoben wird, und
den Schritt des Bildens eines zylindrischen Körperteils des Einkristalls durch Anheben des Kristallzugschaftes zusammen mit dem ersten Element nach dem Schritt des Bildens des Schulterteils, während das Einkristall sich aus der Rohmaterial-Schmelzlösung in dem Einsatztiegel bildet.

2. Verfahren zur Herstellung eines Einkristalls nach Anspruch 1, wobei von dem ersten Schritt der Auffangsstrahlung bis zu dem Schritt der Bildung des Schulterteils die Strahlung weiterhin abgefangen wird mittels Abdecken des ersten Elementes durch ein drittes Element mit einer Öffnung, durch welche das zweite Element hindurchgeht, das über dem ersten Element vorgesehen ist.

3. Verfahren nach Anspruch 1, worin (D-d)/2 innerhalb eines Bereiches von 2 - 20 mm liegt, wobei D den Durchmesser der Öffnung des ersten Elementes und d den Durchmesser des Impfkristalls bezeichnet.

4. Verfahren nach Anspruch 1, worin das erste Element die Rohmaterial-Schmelzlösung innerhalb eines Bereiches von 50 mm über der Rohmaterial-Schmelzlösung abdeckt.

5. Verfahren nach Anspruch 1, worin das erste Element und das zweite Element einstückig ausgebildet sind.

6. Verfahren zur Herstellung eines Einkristalls nach Anspruch 1, worin eine flüssige Abkapselung auf der Rohmaterial-Schmelzlösung angeordnet ist.

7. Verfahren zur Herstellung eines Einkristalls nach Anspruch 1, worin die Strahlung von einer Heizquelle auf die Oberfläche und über der Rohmaterial-Schmelzlösung von dem ersten Schritt des Abfangens der Strahlung bis zum Schritt des Bildens des Schulterteiles abgegeben wird.

8. Verfahren zur Herstellung eines Einkristalles nach Anspruch 1, worin das Ziehen des Einkristalls in einer Atmosphäre ausgeführt wird, die flüchtige Bestandteile enthält.

9. Verfahren zur Herstellung eines Einkristalles nach Anspruch 1, worin die Rohmaterial-Schmelzlösung zur Bildung eines CdTe-Kristalls vorgesehen ist.

10. Vorrichtung zur Herstellung eines Einkristalls, umfassend:
einen Tiegel (3) zum Aufnehmen einer Rohmaterial-Schmelzlösung (5);
einen unteren Schaft (11) zum Halten des Schmelztiegels;
eine Heizung (4), die um den Tiegel angeordnet ist;
einen Einsatztiegel (6), der in dem Tiegel vorgesehen ist und eine Öffnung hat, die in der Lage ist, darin die Rohmaterial-Schmelzlösung aufzunehmen, so daß die Oberfläche der Rohmaterial-Schmelzlösung eine vorgegebene Größe aufweist;
einen drehbaren und vertikal-beweglichen oberen Schaft (8) zum Ziehen des Einkristalls aus der Rohmaterial-Schmelzlösung;
ein erstes Strahlungsabfangelement (1) mit einer Öffnung (1a) im Mittelteil, das beweglich auf dem Einsatztiegel vorgesehen ist und die Oberfläche der Rohmaterial-Schmelzlösung abdeckt, um die Strahlung von der Rohmaterial-Schmelzlösung in den Einsatztiegel nach oben abzufangen; und
ein zweites Strahlungsabfangelement (9), das von dem oberen Schaft gehalten wird und die Öffnung abdeckt, um die Strahlung durch die Öffnung des ersten Strahlungsabfangelementes abzufangen.

11. Vorrichtung zur Herstellung eines Einkristalls nach Anspruch 10, weiterhin umfassend:
ein drittes Strahlungsabfangelement (23) mit einer Öffnung, durch welche das zweite Strahlungsabfangelement hindurchgeht, zum Abdecken des ersten Strahlungsabfangelementes, um weiterhin die Strahlung über dem ersten Strahlungsabfangelement abzufangen.

12. Vorrichtung zur Herstellung eines Einkristalls nach Anspruch 10, worin das erste Strahlungsabfangelement und das zweite Strahlungsabfangelement einstückig ausgebildet sind.

13. Vorrichtung nach Anspruch 10, worin das erste Strahlungsabfangelement (71) gebildet wird durch Übereinanderstapeln von einer Anzahl von scheibenförmigen Elementen (71a,71b) mit Öffnungen von verschiedenen Durchmessern.

14. Vorrichtung nach Anspruch 10, worin (D-d)/2 innerhalb eines Bereiches von 2 - 20 mm liegt, wobei D den Durchmesser der Öffnung des ersten Strahlungsabfangelementes und d den Durchmesser eines Impfkristalls bezeichnet.

15. Vorrichtung zur Herstellung eines Einkristalls nach Anspruch 10, weiterhin umfassend einen luftdichten Behälter (30), der den Tiegel und den Raum zum Ziehen des Kristalls über den Tiegel umgibt, um den

EP 0 509 312 B1

Einkristalls in einer Atmosphäre eines flüchtigen Bestandteiles zu ziehen.

16. Vorrichtung zur Herstellung eines Einkristalls nach Anspruch 10, weiterhin umfassend eine Einrichtung (15), womit die Strahlung von der Heizung die Oberfläche und den Raum über der Rohmaterial-Schmelzlösung erreicht.

17. Vorrichtung zur Herstellung eines Einkristalls nach Anspruch 16, worin die Einrichtung ein Fenster (15) ist, das in einem oberen Teil des Tiegels gebildet wird, zum Aufnehmen der Strahlung von der Heizung.

**Revendications**

1. Procédé pour la fabrication d'un monocristal par mise en contact d'un germe d'inoculation fixé sur l'extrémité inférieure d'un axe de tirage de cristaux avec une solution en fusion de matière première, puis par tirage du germe d'inoculation par l'axe de tirage de cristaux, procédé comprenant :

   l'étape de mise en oeuvre dans la solution en fusion de matière première un coracle ayant une ouverture pouvant y contenir la solution en fusion de matière première afin que la surface de la solution en fusion de matière première ait une dimension prescrite ;

   la première étape d'interception de la radiation en prévoyant un premier élément ayant une ouverture à travers laquelle on fait passer le germe d'inoculation, sur le coracle pour recouvrir la surface de la solution en fusion de matière première dans le coracle pour l'interception de la radiation au-dessus de ce coracle à partir de la solution en fusion de la matière première ;

   la seconde étape d'interception de la radiation en recouvrant l'ouverture d'un second élément supporté par l'axe de tirage des cristaux lorsque le germe d'inoculation est mis en contact avec la solution en fusion de matière première pour l'interception de la radiation à travers cette ouverture ;

   l'étape d'inoculation dans laquelle la radiation est interceptée par le premier élément et par le second élément et l'axe de tirage des cristaux est abaissé pour mettre en contact le germe d'inoculation avec la solution en fusion de matière première ;

   l'étape de formation d'une partie d'épaulement d'un monocristal en interceptant la radiation par le premier élément et par le second élément après l'étape d'inoculation tout en relevant l'axe de tirage des cristaux ; et

   l'étape de formation d'une partie de corps cylindrique du monocristal en relevant l'axe de tirage des cristaux avec le premier élément après l'étape de formation de la partie d'épaulement tout en formant le monocristal à partir de la solution en fusion de matière première dans le coracle.

2. Procédé pour la fabrication d'un monocristal selon la revendication 1, dans lequel à partir de la première étape d'interception de la radiation jusqu'à l'étape de formation de la partie d'épaulement, la radiation est encore interceptée en recouvrant le premier élément d'un troisième élément ayant une ouverture à travers laquelle on fait passer le second élément, ménagée au-dessus du premier élément.

3. Procédé selon la revendication 1, dans lequel
   (D-d)/2 se situe dans la plage de 2 à 20 mm, où D désigne le diamètre de l'ouverture du premier élément et d désigne le diamètre du germe d'inoculation.

4. Procédé selon la revendication 1, dans lequel
   le premier élément recouvre la solution en fusion de matière première à l'intérieur de 50 mm au-dessus de la solution en fusion de matière première.

5. Procédé selon la revendication 1, dans lequel on intègre le premier élément et le second élément.

6. Procédé de fabrication d'un monocristal selon la revendication 1, dans lequel
   on amène un agent d'encapsulation liquide sur la solution en fusion de matière première.

7. Procédé pour la fabrication d'un monocristal selon la revendication 1, dans lequel
   la radiation à partir d'une source de chaleur est transmise à la surface et au-dessus de la solution en fusion de matière première à partir de la première étape d'interception de la radiation jusqu'à l'étape de formation de la partie d'épaulement.

17

**8.** Procédé de fabrication d'un monocristal selon la revendication 1, dans lequel
le tirage du monocristal s'effectue dans une atmosphère incorporant un constituant volatil.

**9.** Procédé de fabrication d'un monocristal selon la revendication 1, dans lequel
la solution en fusion de matière première est destinée à la formation d'un cristal CdTe.

**10.** Appareil pour la fabrication d'un monocristal, comprenant :
un creuset (3) destiné à contenir une solution en fusion de matière première (5) ;
un arbre inférieur (11) destiné à supporter le creuset ;
un élément de chauffage (4) disposé autour du creuset ;
un coracle (6) disposé dans le creuset et ayant une ouverture pouvant y contenir la solution en fusion de matière première afin que la surface de la solution en fusion de la matière première ait une dimension prescrite ;
un axe supérieur rotatif et mobile verticalement (8) destiné à tirer un monocristal à partir de la solution en fusion de matière première ;
un premier élément d'interception de radiation (1) ayant une ouverture (1a) dans la position centrale disposé de façon mobile sur le coracle et recouvrant la surface de la solution en fusion de matière première pour intercepter la radiation en provenance de la solution en fusion de matière première dans le coracle jusqu'au-dessus ; et
un second élément d'interception de radiation (9) monté sur l'axe supérieur et recouvrant l'ouverture destiné à intercepter la radiation par l'ouverture du premier élément d'interception de radiation.

**11.** Appareil pour la fabrication d'un monocristal selon la revendication 10, comprenant de plus
un troisième élément d'interception de radiation (23) doté d'une ouverture à travers laquelle on fait passer le second élément d'interception de radiation, recouvrement du premier élément d'interception de radiation pour intercepter encore la radiation au-dessus du premier élément d'interception de radiation.

**12.** Appareil pour la fabrication d'un monocristal selon la revendication 10, dans lequel
le premier élément d'interception de radiation et le second élément d'interception de radiation sont intégrés.

**13.** Appareil selon la revendication 10, dans lequel le premier élément d'interception de radiation (71) est constitué par un empilage de plusieurs éléments en forme de disque (71, 71b) comportant des ouvertures de différents diamètres.

**14.** Appareil selon la revendication 10, dans lequel (D-d)/2 se situe dans la plage de 2 à 20 mm où D désigne le diamètre de l'ouverture du premier élément d'interception de radiation et d désigne le diamètre du germe d'inoculation.

**15.** Appareil pour la fabrication d'un monocristal selon la revendication 10, comprenant de plus
un conteneur étanche à l'air (30) entourant le creuset et l'espace de tirage destiné à tirer le monocristal dans une atmosphère d'un constituant volatil.

**16.** Appareil pour la fabrication d'un monocristal selon la revendication 10, comprenant de plus
un moyen (15) pour permettre à la radiation provenant de l'élément de chauffage d'atteindre la surface de et de parvenir au-dessus de la solution en fusion de matière première.

**17.** Appareil pour la fabrication d'un monocristal selon la revendication 16, dans lequel
ce moyen est une fenêtre (15) formée au niveau d'une portion supérieure du creuset pour recueillir la radiation provenant de l'élément de chauffage.

FIG.1

( a )

( b )

( c )

# FIG. 2

FIG.3

FIG.4A

FIG.4C

FIG.4B

FIG.4D

FIG.5

FIG.6

FIG.7

# FIG.8

## FIG.9

FIG.10

71b

71a

FIG.11

8

9

2

71b

71a

6

FIG.12

## FIG.13

FIG.14

FIG.15A

FIG.15B

FIG.16

FIG.17

FIG.18

FIG.19

# FIG.20A

# FIG.20B

# FIG.20C

# FIG.20D

# FIG.20E

FIG.21

FIG.22

## FIG.23